# EUROPÄISCHE PATENTSCHRIFT

(11) **EP 1 330 328 B1**
(45) Veröffentlichungstag und Bekanntmachung des Hinweises auf die Patenterteilung: **28.12.2005**
(21) Anmeldenummer: 01986283.8
(22) Anmeldetag: 02.10.2001
(51) Int. Cl.: B23K 3/06, B23K 37/06

(54) **VERFAHREN UND VORRICHTUNG ZUR APPLIKATION VON MATERIALSTÜCKEN AUF EIN WERKSTÜCK**
METHOD AND DEVICE FOR APPLYING MATERIAL TO A WORKPIECE
PROCEDE ET DISPOSITIF POUR APPLIQUER DES FRAGMENTS DE MATERIAU SUR UNE PIECE D'USINAGE

(30) Priorität: 06.10.2000 DE 10049585
(43) Veröffentlichungstag der Anmeldung: 30.07.2003
(73) Patentinhaber: Pac Tech - Packaging Technologies GmbH, 14641 Nauen (DE)
(72) Erfinder: ZAKEL, Elke, 14612 Falkensee (DE); KASULKE, Paul, 74199 Untergruppenbach (DE); UEBEL, Oliver, 10967 Berlin (DE); TITERLE, Lars, 10999 Berlin (DE)
(74) Vertreter: von Bülow, Tam
(86) Internationale Anmeldenummer: PCT/EP2001/011419
(87) Internationale Veröffentlichungsnummer: WO 2002/028588

(56) Entgegenhaltungen:
- WO-A-97/17191
- US-A- 4 661 368
- US-A- 5 148 963
- US-A- 6 093 251

## Beschreibung

Die Erfindung bezieht sich auf ein Verfahren und eine Vorrichtung zur Applikation von Lotmaterial auf ein Werkstück.

US-A-5 148 963 offenbart ein Verfahren und eine Vorrichtung zur Applikation von Materialstücken auf ein Werkstück, wobei eine berührungslase Abstandsmessung mitteln einer, nicht mit Materialstüken beschickbaren, Bohrung durchgeführt wrid.

Die DE 195 41 996 beschreibt eine Vorrichtung zur vereinzelten Applikation von Lotkugeln aus einem Lotkugelreservoir mit einer Applikationseinrichtung und einer Vereinzelungseinrichtung, bei der die Vereinzelungseinrichtung als Kreisfördereinrichtung ausgebildet ist. Durch taktweises Bewegen der Kreisfördereinrichtung werden Lotkugeln von dem Reservoir zu einer Kapillare gefördert und mittels Druckluft zum Ende der Kapillare, die zu diesem Zeitpunkt nahe einer Verbindungsstelle auf dem Werkstück ist. Durch Laserenergie wird die Lotkugel geschmolzen und fließt auf die Verbindungsstelle. In der Kapillare ist ein Drucksensor vorgesehen, der einen statischen Überdruck mißt, der sich bei der Druckgasbeaufschlagung nur dann aufbaut, wenn am Ende der Kapillare eine Lotkugel vorhanden ist und diese unmittelbar über einer Verbindungsstelle liegt. Nur dann erfolgt eine Auslösung des Lasers. Vor der Plazierung kann dort ggf. noch eine Zustellbewegung der Kapillare in vertikaler Richtung erfolgen.

Die genaue Positionierung der Kapillare und die taktgenaue Zuführung von Lotkugeln zum Ende der Kapillare sind wesentliche Voraussetzungen für ein effektives und schnelles Arbeiten der Vorrichtung. Bei der bekannten Vorrichtung sind die Koordinaten der Punkte, an denen Lotkugeln plaziert werden, fest programmiert. Durch Ungenauigkeiten beim Einspannen des Werkstückes, auf dem die Lotkugeln appliziert werden sollen sowie auch durch Maßabweichungen dieses Werkstückes kann es vorkommen, daß die Kapillare nicht immer präzise positioniert ist. Ist sie zu weit von dem Werkstück entfernt, so kann sich die Lotkugel beim "Herunterfallen" zu weit abkühlen, so daß keine ordnungsgemäße Lötstelle erzeugt wird. Ist der Abstand zu gering, so kann es zu einer Kollision zwischen dem Werkstück und der Kapillare kommen, bei der eine oder beide beschädigt werden.

Materialstücke im Sinne der vorliegenden Erfindung können Stücke aus jeglichem Material sein, die in fester oder flüssiger Form vorliegen. Hierbei kann es sich um lötfähige Materialien, wie Gold, Kupfer, Zinn, Glas oder Kunststoff, handeln, die insbesondere als Mikromaterialstücke in Form von Lötkugeln, Glaskugeln oder Kunststoffkugeln vorliegen. Es kann sich auch um Keramikstücke handeln sowie um Bauteile, wie z.B. Miniaturschaltkreise, SMD-Bauteile oder ähnliches. Ganz allgemein kann jegliches Material mit der Erfindung appliziert werden.

Aufgabe der Erfindung ist es, Verfahren und Vorrichtung so auszugestalten, daß eine sehr hohe Applikationsgenauigkeit erreicht wird.

Diese Aufgabe wird durch die in den Patentansprüchen 1, 2 bzw. 11 angegebenen Merkmale gelöst. Vorteilhafte Ausgestaltungen und Weiterbildungen der Erfindung sind den Unteransprüchen zu entnehmen.

Das Grundprinzip der Erfindung besteht darin, während der Vorschubbewegung in vertikaler Richtung (z-Richtung) den Abstand zwischen der Kapillare und dem Werkstück, auf dem das Materialstück plaziert werden soll, dadurch zu messen, daß durch die Kapillare ein Druckgas fließt und der Staudruck dieses Gases am Ende der Kapillare gemessen wird. Sobald nämlich die Spitze der Kapillare dem Werkstück ausreichend nahe gekommen ist, was in der Praxis in der Größenordnung von 400µ liegt, so steigt der Staudruck merklich an und kann zur Abstandsbestimmung in vertikaler Richtung ausgewertet werden.

Dies ist nicht nur dann möglich, wenn Oberfläche des Werkstückes eben ist sondern auch beliebige dreidimensionale Form hat, beispielsweise eine Kavität, wie z.B. eine V-förmige oder rechteckige Nut, eine Stufe, eine Kante oder eine Erhebung.

Sobald über diese Positionsbestimmung in vertikaler Richtung die Kapillare ordnungsgemäß positioniert ist, wird durch die im Prinzip bekannte Zufuhreinrichtung ein Materialstück zum Ende der Kapillare gebracht. Diese verschließt dann die Kapillare weitestgehend vollständig, wodurch der Staudruck weiter ansteigt, was das Vorkommen des Materialstückes signalisiert. Nach einer Variante der Erfindung wird dann das Materialstück durch Zurückziehen der Kapillare freigesetzt. Nach einer anderen Variante der Erfindung, die sich auf lötfähige Materialstücke bezieht, wird in Abhängigkeit von diesem Signal dann ein Laser zum Schmelzen des Materialstückes aktiviert.

Bei einer Ausgestaltung der Erfindung, die sich auf lötfähiges Material bezieht, kann die Spitze der Kapillare soweit verjüngt sein, daß ihre Öffnungsweite kleiner ist als der Durchmesser des Materialstückes. Dadurch wird das Materialstück noch am Ende der Kapillare gehalten, auch wenn der Abstand zwischen der Spitze der Kapillare und dem Werkstück größer ist als der Radius des Materialstückes.

In Abhängigkeit von dem oben genannten Signal wird dann eine Wärmequelle zum Schmelzen der Lotkugel aktiviert. Diese Wärmequelle kann beispielsweise ein Laser, ein Infrarotstrahl, Warmluft, ein Erhitzen der Spitze der Kapillare oder sonstige Energiezufuhr sein, die zum Umschmelzen des Materialstückes führt.

Das Verfahren nach der Erfindung beinhaltet die Schritte:
- Positionieren der Kapillare, wobei zumindest bei Bewegung in vertikaler Richtung ein Druckgas durch die Kapillare geleitet wird und der Staudruck in der Kapillare gemessen wird;
- Beenden des Vorschubes in vertikaler Richtung, wenn der Staudruck einen vorbestimmten Wert erreicht hat;
- Zuführen eines Materialstückes zur Spitze der Kapillare;
- weiterhin Messen des Staudruckes und
- entweder Auslösen eines Lasers zum Schmelzen des Materialstückes, wenn der Staudruck einen zweiten größeren Wert erreicht hat,
- Freisetzen des Materialstückes durch Zurückziehen der Kapillare.

Im folgenden wird die Erfindung anhand eines Ausführungsbeispieles im Zusammenhang mit der Zeichnung ausführlicher erläutert. Es zeigt:
- Fig. 1: eine Prinzipskizze einer Vorrichtung nach der Erfindung;
- Fig. 2a bis 2f: eine vergrößerte Ansicht der Spitze der Kapillare bei verschiedenen Oberflächen des Werkstückes.

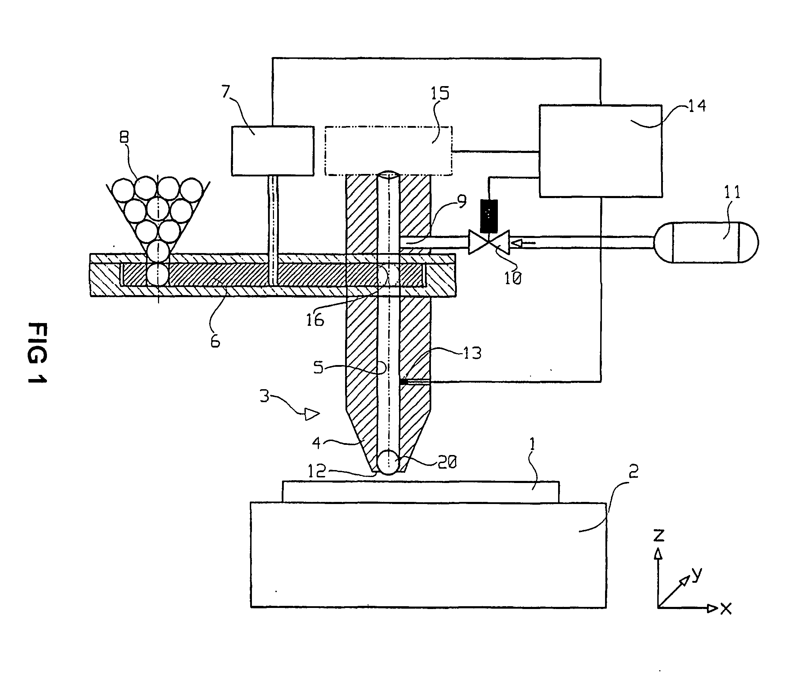

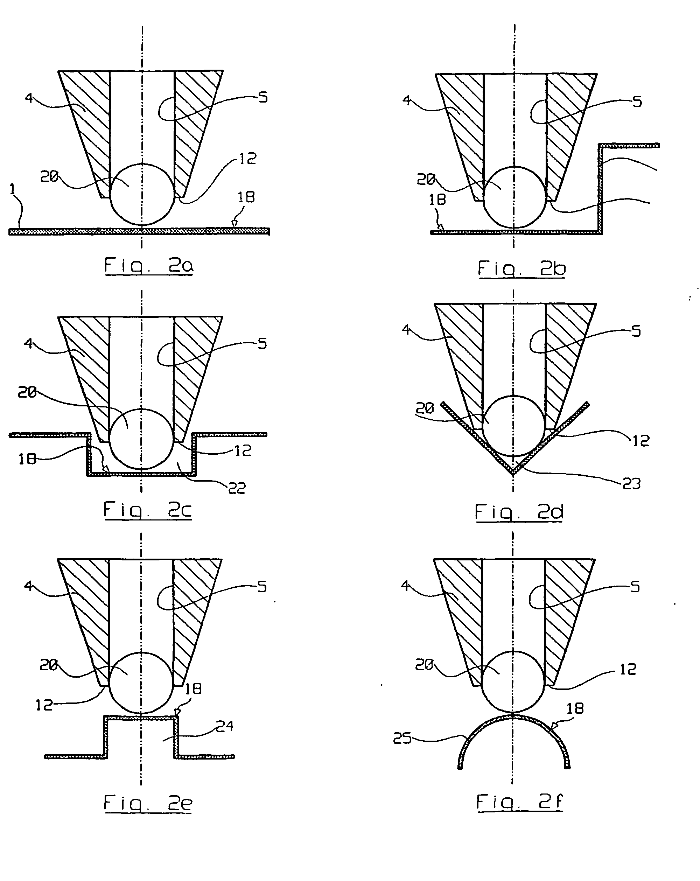

Obwohl sich die Ausführungsbeispiele der Fig. 1 und 2 auf die Applikation von Lotkugeln beziehen, sei ausdrücklich darauf hingewiesen, daß jegliche Materialstücke, wie eingangs definiert, appliziert werden können.

Zunächst wird auf Fig. 1 Bezug genommen. Ein Werkstück 1, auf dem Lotkugeln aufgelötet werden sollen, ist an einem Kreuztisch 2 befestigt, der relativ zu einer Applikationseinrichtung 3 in zumindest drei karthesischen Raumkoordinaten x, y und z bewegt werden kann. Selbstverständlich ist es auch möglich, die Applikationseinrichtung 3 relativ zu einem feststehenden Tisch 2 zu bewegen oder die Bewegung aufzuteilen, beispielsweise daß der Tisch Bewegungen in x-, y-Richtung ausführen kann, während die Applikationseinrichtung in z-Richtung beweglich ist.

Die Applikationseinrichtung 3 hat eine Kapillare 4 mit einer Bohrung 5, deren Durchmesser im wesentlichen dem Durchmesser einer Lotkugel 20 entspricht. Eine Fördereinrichtung 6 in Form einer drehbaren Scheibe, die von einem Motor 7 angetrieben wird, hat eine Vielzahl von Löchern, die als Aufnahme für Lotkugeln dienen. In einem Reservoir 8 befindet sich ein Vorrat an Lotkugeln, die durch die Fördereinrichtung 6 vereinzelt und zur Bohrung 5 transportiert werden.

In die Bohrung 5 mündet eine Querbohrung 9, über die ein Druckgas der Bohrung zugeführt wird. Über ein steuerbares Ventil 10 kann dabei das Druckgas aus einem Vorratsbehälter 11 bzw. einem Druckerzeuger durch die Bohrung fließen und eine Lotkugel von der Fördereinrichtung 6 zur Spitze 12 der Kapillare 4 fördern. In der Bohrung 5 ist ein Drucksensor 13 angeordnet, der den Staudruck des Druckgases in der Bohrung 5 mißt. Ein Signal von dem Drucksensor wird einer Steuereinrichtung 14 zugeführt, die den Motor 7, das Ventil 10 und eine Lasereinrichtung 15 sowie die Vorschubbewegungen zwischen Kapillare 3 und Kreuztisch 2 steuert.

### Die Arbeitsweise der Vorrichtung ist wie folgt:

Es sei angenommen, daß eine Lotkugel gerade gesetzt wurde und die Bohrung 5 frei durchgängig ist. Die Kapillare 4 wird jetzt zur nächsten Stelle verfahren, an der eine weitere Lotkugel gesetzt werden soll. Dabei wird auch eine Bewegung in vertikaler Richtung, d.h. in z-Richtung, durchgeführt. Sobald sich die Spitze 12 der Kapillare der nächsten Lötstelle nähert und eine Zustellbewegung in z-Richtung erforderlich ist, schaltet die Steuereinrichtung 14 das Ventil 10, so daß Druckgas, wie z.B. ein Schutzgas, durch die Bohrung 5 und auch die zu diesem Zeitpunkt freie Öffnung 16 in der Fördereinrichtung 6 fließt. Der Drucksensor 13 mißt dann den Staudruck und meldet ihn an die Steuereinrichtung 14, die die Zustellbewegung in z-Richtung solange weiter veranlaßt, bis der Staudruck einen vorgegebenen Wert erreicht hat. Sodann wird die Zustellbewegung in z-Richtung beendet und die Steuereinrichtung 14 steuert den Motor 7 an, so daß die Fördereinrichtung 6 eine neue Lotkugel vom Reservoir 8 zur Bohrung 5 fördert. Während dieser Förderbewegung kann das Ventil 10 geöffnet oder geschlossen sein. Sobald eine neue Lotkugel die Bohrung 5 erreicht hat, wird durch das Druckgas die Kugel in Richtung zur Spitze 12 der Kapillare gefördert. Sobald die Kugel die Spitze 12 erreicht hat, steigt der Staudruck an dem Drucksensor 13 weiter an. Sobald er einen vorbestimmten Wert erreicht hat, aktiviert die Steuereinrichtung 14 die Lasereinrichtung 15 und ein durch die Bohrung 5 geleiteter Laserstrahl schmilzt die Lotkugel 6. Sodann kann ein neuer Arbeitstakt beginnen. Im Falle, daß das Materialstück nicht aufgeschmolzen werden soll, wird selbstverständlich die Lasereinrichtung nicht benötigt und das Materialstück wird durch Zurückziehen der Kapillare freigesetzt.

Fig. 2 zeigt die Kapillare 4 mit Bohrung 5 und einem Materialstück in Form einer Lotkugel 20, die auf ein Werkstück 1 bzw. auf ein Substrat plaziert werden soll. In Fig. 2a ist die Oberfläche 18 des Werkstückes 1 vollständig eben. In Fig. 2b befindet sich die Applikationsstelle nahe einer Stufe 21. In Fig. 2c ist die Applikationsstelle eine Kavität und zwar hier in Form einer rechteckigen Nut 22. In Fig. 2d ist die Kavität eine V-förmige Rille 23. Eine solche Rille kann beispielsweise an Stellen entstehen, wo zwei Leiterplatten senkrecht zueinander stehen.

In Fig. 2e ist die Applikationsstelle auf einer Erhebung 24, die ihrerseits eine ebene Oberfläche 18 hat, während in Fig. 2f die Applikationsstelle auf einer Erhebung 25 liegt, die abgerundet ist.

Dem Fachmann ist klar, daß der sich aufbauende Staudruck beim Heranführen der Kapillare 4 an die Oberfläche des Werkstückes 1 von der Form bzw. Struktur der Oberfläche abhängt. So wird der Staudruck in den Fällen der Fig. 2c und 2d schneller ansteigen und höhere Werte erreichen als beispielsweise in den Fällen der Fig. 2a, 2e und 2f. Gleichwohl hat sich herausgestellt, daß auch in diesen Fällen bei der Annäherung der Kapillare an die Oberfläche eine signifikante Staudruckerhöhung auftritt, die ein präzises Signal für den Abstand bei der Zustellbewegung ableiten läßt. Je nach Anwendungsfall ist lediglich der Ansprechschwellwert einzustellen.

In den Ausführungsbeispielen der Fig. 2a bis 2f hat die Bohrung 5 durchgängig einen einheitlichen Durchmesser. Die Spitze wird dann so nahe über dem Gegenstand 1 positioniert, daß ihr Abstand dem Radius der Lotkugel entspricht. Die Lotkugel wird dann zwischen der Bohrung 5 und der Oberfläche des Gegenstandes 1 gehalten und verschließt dadurch ebenfalls die Bohrung 5, was den Staudruck ansteigen läßt und damit ein signifikantes Signal für das Vorhandensein einer Lotkugel an der Spitze 12 liefert.

Für manche Anwendungsfälle kann es auch erforderlich sein, an der Spitze 12 der Bohrung 5 eine nicht dargestellte Verengung vorzusehen, die das Materialstück hält. Erst durch Aufschmelzen kann es dann aus der Bohrung herausgelangen.

Schließlich sei noch darauf hingewiesen, daß die Erfindung auch für das Aufnehmen bzw. Entfernen von Materialstücken von der Oberfläche eines Gegenstandes verwendet werden kann. Zum Reparieren defekter Lötstellen kann hierbei wiederum der Laser eingesetzt werden, der dann aktiviert wird, wenn der Staudruck anzeigt, daß ein vorgegebener Abstand zur Oberfläche des Werkstückes erreicht ist. Durch den Laser kann dann die Lötstelle aufgeschmolzen und das flüssige Lötzinn durch die Kapillare 5 abgesaugt werden. Der Begriff der Applikation ist daher auch in diesem erweiterten Sinne des Aufbringens und/oder Entfernens zu verstehen.

Generell wäre es auch möglich, die Bohrung 5 mit einem einheitlich durchgehenden Durchmesser zu versehen. Die Spitze 12 wird dann so nahe über dem Gegenstand 1 positioniert, daß ihr Abstand in etwa dem Radius der Lotkugel entspricht. Die Lotkugel wird dann zwischen der Bohrung 5 und der Oberfläche des Gegenstandes 1 gehalten und verschließt dadurch ebenfalls die Bohrung 5, was den Staudruck ansteigen läßt.

In manchen Fällen muß eine Lotkugel auch in eine V-förmige Rille eingebracht werden, beispielsweise an Stellen, wo zwei Leiterplatten senkrecht zueinander stehen, wie es mit der V-förmigen Rille 18 in Fig. 2 dargestellt ist. Auch hier ist der Staudruck signifikant für den Abstand bei der Zustellbewegung in z-Richtung und auch signifikant für das Vorhandensein einer Lotkugel an der Spitze 12. Für eine solche Applikation ist es vorteilhaft, wenn die Spitze der Kapillare die Verjüngung 17 hat.

## Patentansprüche

1. Verfahren zur Applikation von in einer Bohrung einer Kapillare befindlichen Materialstücken auf ein Werkstück mit folgenden Arbeitsschritten:
- Einleiten eines Druckgases in eine Bohrung einer Kapillare mit Messen des Staudruckes in der Bohrung zumindest während einer Zustellbewegung der Kapillare in vertikaler Richtung zu dem Werkstück hin,
- Beenden der Zustellbewegung, wenn der Staudruck einen ersten vorgegebenen Wert erreicht hat,
- Fördern eines Materialstückes durch die Bohrung hindurch zur spitze der Kapillare unter weiterem Einleiten des Druckgases, und
- Freisetzen des Materialstückes durch Zurückziehen der Kapillare.

2. Verfahren zur Applikation von in einer Bohrung einer Kapillare befindlichen Materialstücken auf ein Werkstück mit folgenden Arbeitsschritten:
- Einleiten eines Druckgases in eine Bohrung einer Kapillare mit Messen des Staudruckes in der Bohrung zumindest während einer Zustellbewegung der Kapillare in vertikaler Richtung zu dem Werkstück hin,
- Beenden der Zustellbewegung, wenn der Staudruck einen ersten vorgegebenen Wert erreicht hat,
- Fördern eines Materialstückes durch die Bohrung hindurch zur Spitze der Kapillare unter weiterem Einleiten des Druckgases, und
- Messen des Staudruckes in der Bohrung und Auslösen einer Wärmequelle zum Schmelzen des Materialstückes, wenn der Staudruck einen zweiten vorgegebenen Wert erreicht.

3. Verfahren nach Anspruch 1 oder 2, **dadurch gekennzeichnet,**
**daß** die Materialstücke schmelzbares Material, wie Lötmaterial, insbesondere Gold, Kupfer, Zinn, Glas oder Kunststoff sind, die in fester oder flüssiger Form vorliegen, oder Keramikstücke.

4. Verfahren nach Anspruch 2, **dadurch gekennzeichnet, daß** der zweite vorgegebene Wert größer ist als der erste vorgegebene Wert.

5. Verfahren nach einem der Ansprüche 1 bis 4, **dadurch gekennzeichnet,**
**daß** das Werkstück an der Applikationsstelle eine dreidimensionale Struktur aufweist.

6. Verfahren nach Anspruch 5, **dadurch gekennzeichnet, daß** das Werkstück an der Applikationsstelle eine Kavität (22, 23) aufweist.

7. Verfahren nach Anspruch 6, **dadurch gekennzeichnet, daß** die Kavität eine V-förmige Rille (23) aufweist.

8. Verfahren nach Anspruch 6, **dadurch gekennzeichnet, daß** die Kavität eine Nut (22) ist.

9. Verfahren nach einem der Ansprüche 1 bis 4, **dadurch gekennzeichnet,**
**daß** das Werkstück an der Applikationsstelle eine Erhebung (24, 25) aufweist.

10. Verfahren nach einem der Ansprüche 1 bis 4, **dadurch gekennzeichnet,**
**daß** das Werkstück an der Applikationsstelle eben ist.

11. Vorrichtung zur Applikation von Materialstücken auf ein Werkstück, wobei die Vorrichtung folgendes umfaßt: eine relativ zu dem Werkstück (1) bewegliche Kapillare (4) mit einer mit Materialstücken beschickbaren Bohrung (5), eine Druckgasquelle (11) zur Zuleitung von Druckgas zu der Bohrung (5), einen Sensor (13) zur Messung des Staudruckes des Druckgases in der Bohrung und eine Steuereinheit (14), die eine Zustellbewegung der Kapillare in vertikaler Richtung zu dem Gegenstand (1) in Abhängigkeit von dem Ausgangssignal des Sensors (13) steuert.

12. Vorrichtung nach Anspruch 11, **dadurch gekennzeichnet, daß** die Kapillare (4) eine Spitze (12) aufweist, wobei die Spitze (12) der Kapillare (4) eine Verjüngung (17) aufweist, deren Durchmesser kleiner ist als der Durchmesser eines in Form von Materialstücken auf das Werkstück (1) aufzubringenden Lotmaterials (20).

## Claims

1. Method for application of pieces of material located in a bore hole of a capillary to a workpiece with the following steps:
- introduction of a compressed gas into a bore hole with measurement of the dynamic pressure in the bore hole at least during a feed motion of the capillary in the vertical direction toward the workpiece,
- ending the feed motion when the dynamic pressure has reached a first preset value,
- conveyance of a piece of material through the bore hole to the tip of the capillary with further introduction of the compressed gas, and
- release of the piece of material by withdrawal of the capillary.

2. Method for application of pieces of material located in a bore hole of a capillary to a workpiece with the following steps:
- introduction of a compressed gas into a bore hole with measurement of the dynamic pressure in the bore hole at least during a feed motion of the capillary in the vertical direction toward the workpiece,
- ending the feed motion when the dynamic pressure has reached a first preset value,
- conveyance of a piece of material through the bore hole to the tip of the capillary with further introduction of the compressed gas, and
- measurement of the dynamic pressure in the bore hole and release of a heat source for melting the piece of material when the dynamic pressure has reached a second preset value.

3. Method according to claim 1 or 2, **characterized in that** the pieces of meltable material include solder material, particularly gold, copper, tin, glass or plastic, which are present in solid or liquid form, or pieces of ceramic.

4. Method according to claim 2, **characterized in that** the second preset value is greater than the first preset value.

5. Method according to one of claims 1 to 4, **characterized in that** the workpiece at the application point has a three-dimensional structure.

6. Method according to claim 5, **characterized in that** the workpiece at the application point has a cavity (22, 23).

7. Method according to claim 6, **characterized in that** the cavity has a V-shaped slot (23).

8. Method according to claim 6, **characterized in that** the cavity is a groove (22).

9. Method according to one of claims 1 to 4, **characterized in that** the workpiece at the application point has an elevation (24, 25).

10. Method according to one of claims 1 to 4, **characterized in that** the workpiece at the application point is flat.

11. Device for application of pieces of material to a workpiece, the device comprising:
a capillary (4) moving relative to the workpiece (1) with a bore hole (5) chargeable with pieces of material, a compressed gas source (11) for supplying compressed gas to the bore hole (5), a sensor (13) for measurement of the dynamic pressure of the compressed gas in the bore hole and a controller (14) which controls a feed motion of the capillary in the vertical direction toward the object (1) as a function of the output signal of the sensor (13).

12. Device according to claim 11, **characterized in that** the capillary (4) has a tip (12), said tip (12) of the capillary (4) having a narrowing (17) the diameter of which is smaller than the diameter of a solder material (20) in the form of pieces of material to be applied to the workpiece (1).

## Revendications

1. Procédé pour appliquer sur une pièce d'usinage des fragments de matériau se trouvant dans l'alésage d'un tube capillaire, avec les étapes suivantes :
- introduction d'un gaz comprimé dans l'alésage d'un tube capillaire, avec mesure de la pression dynamique dans l'alésage au moins pendant un mouvement d'avance du tube capillaire dans le sens vertical en direction de la pièce d'usinage,
- achèvement du mouvement d'avance quand la pression dynamique a atteint une première valeur prédéterminée,
- transport d'un fragment de matériau à travers l'alésage jusqu'à la pointe du tube capillaire en continuant d'introduire le gaz comprimé, et
- libération du fragment de matériau par le retrait du tube capillaire.

2. Procédé pour appliquer sur une pièce d'usinage des fragments de matériau se trouvant dans l'alésage d'un tube capillaire, avec les étapes suivantes :
- introduction d'un gaz comprimé dans l'alésage d'un tube capillaire, avec mesure de la pression dynamique dans l'alésage au moins pendant un mouvement d'avance du tube capillaire dans le sens vertical en direction de la pièce d'usinage,
- achèvement du mouvement d'avance quand la pression dynamique a atteint une première valeur prédéterminée,
- transport d'un fragment de matériau à travers l'alésage jusqu'à la pointe du tube capillaire en continuant d'introduire le gaz comprimé, et
- mesure de la pression dynamique dans l'alésage et déclenchement d'une source de chaleur pour fondre le fragment de matériau quand la pression dynamique a atteint une deuxième valeur prédéterminée.

3. Procédé selon la revendication 1 ou 2, **caractérisé en ce que** les fragments de matériau sont en un matériau fusible tel qu'un matériau de brasage, notamment de l'or, du cuivre, de l'étain, du verre ou une matière plastique, lesquels se présentent sous forme solide ou liquide, ou bien sont des fragments de céramique.

4. Procédé selon la revendication 2, **caractérisé en ce que** la deuxième valeur prédéterminée est supérieure à la première valeur prédéterminée.

5. Procédé selon l'une des revendications 1 à 4, **caractérisé en ce que**
à l'endroit d'application, la pièce d'usinage présente une structure tridimensionnelle.

6. Procédé selon la revendication 5, **caractérisé en ce que** à l'endroit d'application, la pièce d'usinage présente une cavité (22, 23).

7. Procédé selon la revendication 6, **caractérisé en ce que** la cavité présente une rainure en V (23).

8. Procédé selon la revendication 6, **caractérisé en ce que** la cavité est une gorge (22).

9. Procédé selon l'une des revendications 1 à 4, **caractérisé en ce que**
à l'endroit d'application, la pièce d'usinage présente une saillie (24, 25).

10. Procédé selon l'une des revendications 1 à 4, **caractérisé en ce que**
à l'endroit d'application, la pièce d'usinage est plane.

11. Dispositif pour appliquer des fragments de matériau sur une pièce d'usinage, le dispositif comprenant les éléments suivants :
un tube capillaire (4) mobile par rapport à la pièce d'usinage (1) et muni d'un alésage (5) pouvant être alimenté en fragments de matériau, une source de gaz comprimé (11) pour amener du gaz comprimé à l'alésage (5), un capteur (13) pour mesurer la pression dynamique du gaz comprimé dans l'alésage, et une unité de commande (14) qui commande un mouvement d'avance du tube capillaire dans le sens vertical vers l'objet (1) en fonction du signal de sortie du capteur (13).

12. Dispositif selon la revendication 11, **caractérisé en ce que** le tube capillaire (4) présente une pointe (12), la pointe (12) du tube capillaire (4) présentant un rétrécissement (17) dont le diamètre est inférieur au diamètre d'un matériau de brasage (20) à appliquer sous forme de fragments de matériau sur la pièce d'usinage (1).
